# EUROPEAN PATENT APPLICATION

(11) **EP 4 811 342 A1**
(43) Date of publication of application: **23.09.2026**
(21) Application number: 26165960.1
(22) Date of filing: 19.03.2026
(51) Int. Cl.: G09G 3/34, G11C 19/28, G02F 1/167, G09G 3/36

(54) **DISPLAY DEVICE**

(30) Priority: 19.03.2025 US 202563774111 P
(71) Applicant: E Ink Holdings Inc., 30078 Hsinchu (TW)
(72) Inventor: HUANG, Wei-Kai, Hsinchu (TW); WU, Chia-Hsien, Hsinchu (TW); CHANG, Chun Kai, Hsinchu (TW); KUO, Wen-Yu, Hsinchu (TW); LIANG, Kuang-Heng, Hsinchu (TW); CHEN, Wei-Tsung, Hsinchu (TW)
(74) Representative: Becker, Eberhard

(57) **Abstract**

A display device (100) is provided. The display device (100) includes a pixel array (110) and a gate driver circuit (120). The pixel array (110) includes a plurality of pixel units (P(1,1) to P(M,N)). The gate driver circuit includes a plurality of stages of gate drivers (G1a to G(N+2)a, G1b to G(N)b, G1a' to G(N+2)a', G1b' to G(N)b'). At least one stage of the plurality of stages of gate drivers (G1a to G(N+2)a, G1a' to G(N+2)a') is configured to receive a first clock signal, and has a main output terminal (G_out, G_outl) configured to output a first gate drive signal (GS1). At least another stage of the plurality of stages of gate drivers (G1b to G(N)b, G1b' to G(N)b') is configured to receive a second clock signal, and has a boost output terminal (G_out2) configured to output a second gate drive signal (GS2).

## Description

### BACKGROUND

### Technical Field

The invention relates to a device, and particularly relates to a display device.

### Description of Related Art

As the design requirements for display driving evolve, pixel circuits may need a plurality of gate drive signals to operate, thereby causing an increase in the number of gate drivers and/or circuit components in the gate driver circuit, which increases the layout space occupied by the gate driver circuit. As a result, this is disadvantageous for applications in narrow bezel and high-resolution display devices.

### SUMMARY

The invention provides a display device that may effectively reduce the layout area of the gate driver circuit.

The display device of the invention includes a pixel array and a gate driver circuit. The pixel array includes a plurality of pixel units. The gate driver circuit is coupled to the pixel array, and includes a plurality of stages of gate drivers. At least one stage of the plurality of stages of gate drivers is configured to receive a first clock signal, and has a main output terminal configured to output a first gate drive signal. At least another stage of the plurality of stages of gate drivers is configured to receive a second clock signal, and has a boost output terminal configured to output a second gate drive signal. The gate driver to which the boost output terminal belongs shares a control circuit with the gate driver to which the main output terminal of at least one adjacent stage belongs.

Based on the above, the display device of the invention may effectively reduce the layout area of the gate driver circuit through at least two stages of the plurality of stages of the gate drivers sharing the control circuit.

To make the aforementioned more comprehensible, several embodiments accompanied with drawings are described in detail as follows.

### BRIEF DESCRIPTION OF THE DRAWINGS

The accompanying drawings are included to provide a further understanding of the disclosure, and are incorporated in and constitute a part of this specification. The drawings illustrate exemplary embodiments of the disclosure and, together with the description, serve to explain the principles of the disclosure.
FIG. 1 is a schematic diagram of a display device according to an embodiment of the invention.
FIG. 2 is a schematic diagram of a pixel circuit according to an embodiment of the invention.
FIG. 3 is a schematic diagram of a gate driver circuit according to an embodiment of the invention.
FIG. 4 is a schematic diagram of an equivalent circuit according to an embodiment of the invention.
FIG. 5 is a schematic diagram of a pixel array and a gate driver circuit according to an embodiment of the invention.
FIG. 6 is a schematic diagram of a pixel array and a gate driver circuit according to another embodiment of the invention.
FIG. 7 is a schematic diagram of a gate driver according to an embodiment of the invention.
FIG. 8 is a schematic diagram of another gate driver according to an embodiment of the invention.
FIG. 9 is a timing diagram of a plurality of signals of the embodiments of FIG. 7 and FIG. 8 of the invention.

### DESCRIPTION OF THE EMBODIMENTS

In order to make the content of the invention more easily understood, the following specific embodiments are provided as examples that the invention can indeed be implemented accordingly. In addition, wherever possible, elements/components/steps using the same reference numerals in the drawings and embodiments represent the same or similar parts.

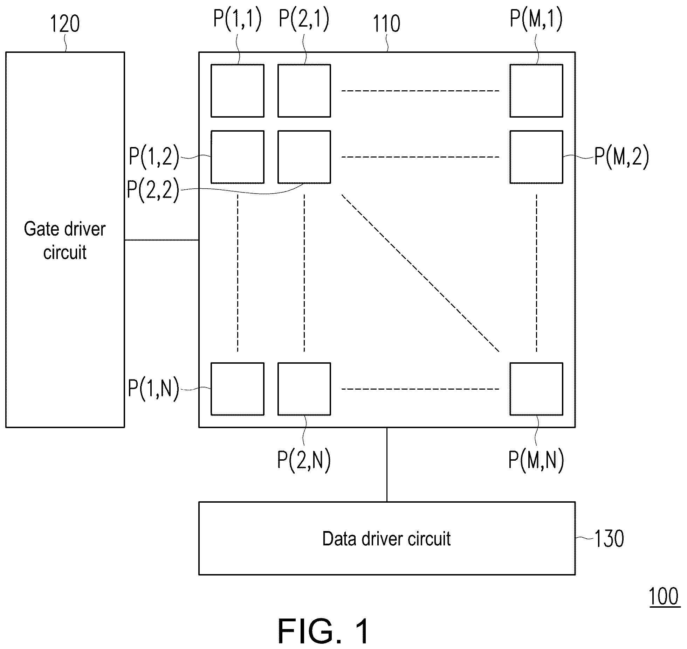

FIG. 1 is a schematic diagram of a display device according to an embodiment of the invention. Referring to FIG. 1, the display device 100 includes a pixel array 110, a gate driver circuit 120, and a data driver circuit 130 (also referred to as a source driver circuit). The pixel array 110 is coupled to the gate driver circuit 120 and the data driver circuit 130. The pixel array 110 includes a plurality of pixel units P(1,1) to P(M,N), where M and N are positive integers. The gate driver circuit 120 may be coupled to the pixel units P(1,1) to P(M,N) through a plurality of gate signal lines. The data driver circuit 130 may be coupled to the pixel units P(1,1) to P(M,N) through a plurality of data signal lines (also referred to as source signal lines). In one embodiment, the display device 100 may be a bistable display, such as an electrophoretic display (EPD). In one embodiment, the display device 100 is an electronic paper display. Each of the pixel units P(1,1) to P(M,N) may include a display element, such as a microcapsule or a microcup.

In one embodiment, the pixel array 110 may be a thin film transistor (TFT) array. Each of the pixel units P(1,1) to P(M,N) includes a pixel circuit, where the pixel circuit is formed on a glass substrate. The pixel circuit is configured to generate a voltage according to at least one gate drive signal and at least one data signal (also referred to as a source drive signal) to drive a corresponding display element. In one embodiment, the gate driver circuit 120 includes a plurality of gate drivers, and the plurality of gate drivers are formed on the glass substrate in a gate on array (GOA) manner. The pixel array 110 and the gate driver circuit 120 may be formed on the same glass substrate.

In addition, in the description of the following embodiments, the first terminal and the second terminal of the transistor may be a drain or a source terminal respectively, and the control terminal of the transistor may be a gate terminal, but the invention is not limited thereto. The polarity of each terminal of the transistor may be determined according to different transistor types.

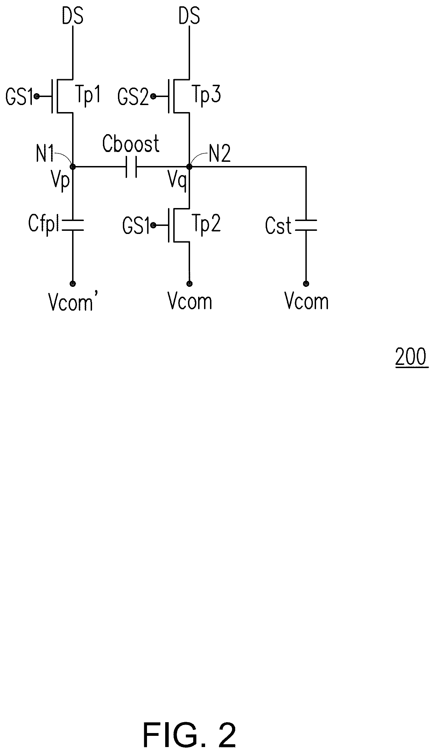

FIG. 2 is a schematic diagram of a pixel circuit according to an embodiment of the invention. Referring to FIG. 2, in one embodiment, each of the pixel units P(1,1) to P(M,N) in FIG. 1 may have the circuit architecture of the pixel circuit 200 as shown in FIG. 2. The pixel circuit 200 includes pixel transistors Tp1 to Tp3, a bootstrap capacitor Cboost, a pixel capacitor Cfpl, and a storage capacitor Cst. A first terminal of the pixel transistor Tp1 receives a data signal DS. A second terminal of the pixel transistor Tp1 is coupled to a node N1. A control terminal of the pixel transistor Tp1 receives a first gate drive signal GS1. A first terminal of the pixel transistor Tp2 is coupled to a node N2. A second terminal of the pixel transistor Tp2 receives a reference voltage Vcom. A control terminal of the pixel transistor Tp2 receives the first gate drive signal GS1. The reference voltage Vcom may be a common electrode voltage. A first terminal of the pixel transistor Tp3 receives the data signal DS. A second terminal of the pixel transistor Tp3 is coupled to the node N2. A control terminal of the pixel transistor Tp3 receives a second gate drive signal GS2. A first terminal of the bootstrap capacitor Cboost is coupled to the node N1, and a second terminal of the bootstrap capacitor Cboost is coupled to the node N2. A first terminal of the pixel capacitor Cfpl is coupled to the node N1. A second terminal of the pixel capacitor Cfpl receives a reference voltage Vcom'. The reference voltage Vcom' may be a common electrode voltage of the pixel array. A first terminal of the storage capacitor Cst is coupled to the node N2. A second terminal of the storage capacitor Cst receives the reference voltage Vcom.

In another embodiment, each of the pixel units P(1,1) to P(M,N) in FIG. 1 may have another circuit architecture of a pixel circuit. Specifically, the another pixel circuit includes a first pixel transistor, a second pixel transistor, a first capacitor (bootstrap capacitor), and a second capacitor (storage capacitor). A control terminal of the first pixel transistor is coupled to a first gate signal line to receive a first gate drive signal GS1. A first terminal of the first pixel transistor is coupled to a data signal line to receive a data signal. A second terminal of the first pixel transistor is coupled to the first node N1. A control terminal of the second pixel transistor is coupled to a second gate signal line to receive a second gate drive signal GS2. A first terminal of the second pixel transistor is coupled to the data signal line to receive the data signal. A second terminal of the second pixel transistor is coupled to the second node N2. The first capacitor is coupled between the first node N1 and the second node N2. The second capacitor is coupled to the second node N2 and receives a reference voltage. The first node N1 is configured to provide a pixel voltage. Under such architecture, the number of transistors in the another pixel circuit is two, which may further reduce the area of the pixel circuit compared to a three-transistor pixel circuit.

In yet another embodiment, the first terminal of the first pixel transistor of the another pixel circuit may be coupled to a first data signal line to receive a first data signal. The first terminal of the second pixel transistor may be coupled to a second data signal line to receive a second data signal, wherein the first data signal and the second data signal may be respectively output by the data driver circuit 130. By using two independent data signal lines, the data signals with different voltage levels may be respectively transmitted in a first period and a second period, further enhancing the design flexibility of the bootstrap boost amplitude of the pixel voltage.

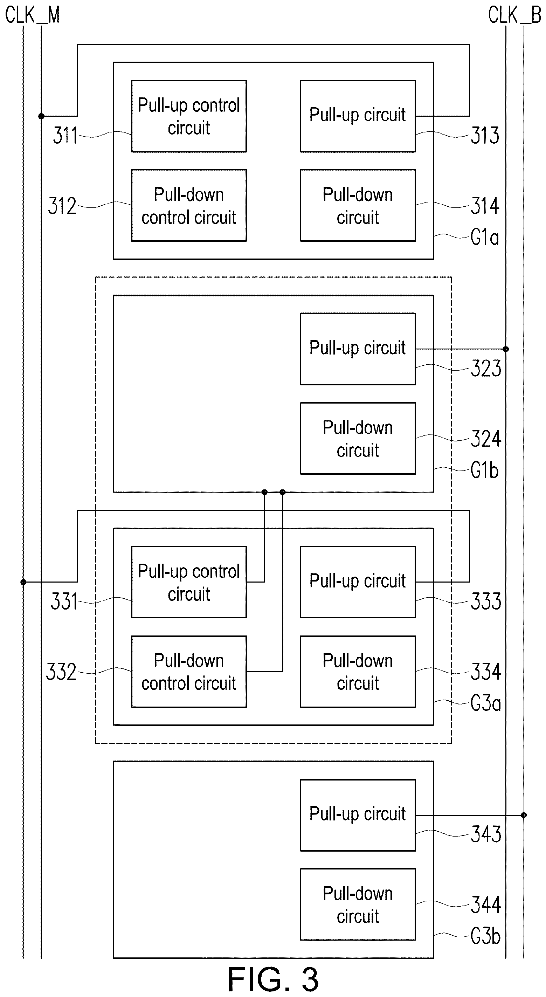

FIG. 3 is a schematic diagram of a gate driver circuit according to an embodiment of the invention. Referring to FIG. 3, the gate driver circuit 120 of FIG. 1 may include a plurality of stages of the gate drivers. The following description takes adjacent gate drivers G1a, G1b, G3a, G3b as examples. The gate driver G1a includes a pull-up control circuit 311, a pull-down control circuit 312, a pull-up circuit 313, and a pull-down circuit 314. The gate driver G1b includes a pull-up circuit 323 and a pull-down circuit 324. The gate driver G3a includes a pull-up control circuit 331, a pull-down control circuit 332, a pull-up circuit 333, and a pull-down circuit 334. The gate driver G3b includes a pull-up circuit 343 and a pull-down circuit 344. In the embodiment, the pull-up circuits 313, 333 receive a first clock signal CLK_M (main clock signal), and the gate drivers G1a, G3a have main output terminals for outputting the first gate drive signals. The pull-up circuits 323, 343 receive a second clock signal CLK_B (boost clock signal), and the gate drivers G1b, G3b have boost output terminals for outputting second gate drive signals. The first gate drive signal output by the gate driver G1a and the second the gate drive signal output by the gate driver G1b are respectively coupled to the same row of the plurality of pixel units. Additionally, in the embodiment, the voltage amplitude of the second clock signal CLK_B is different from the voltage amplitude of the first clock signal CLK_M.

In the embodiment, the gate driver G1b and the gate driver G3a share the pull-up control circuit 331 and the pull-down control circuit 332. In other words, the gate driver to which the boost output terminal belongs and the gate driver to which the main output terminal of at least one adjacent stage belongs may share the control circuits (i.e., the pull-up control circuit and the pull-down control circuit described in the following embodiments), but the invention is not limited thereto. In one embodiment, the gate driver to which the boost output terminal belongs may also share the control circuits with at least two adjacent stages of the gate drivers.

Additionally, it should be noted that compared to conventional gate driver circuits, the adjacent gate drivers in conventional gate driver circuits only receive the same clock signal and do not share control circuit. Therefore, compared to conventional gate driver circuits, the layout area of the gate driver circuit of the embodiment may be effectively reduced.

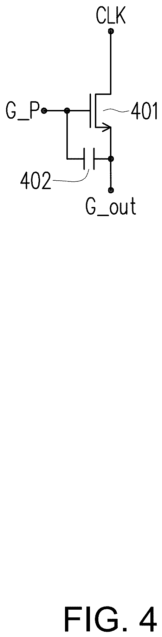

FIG. 4 is a schematic diagram of an equivalent circuit according to an embodiment of the invention. Referring to FIG. 4, the gate driver circuit described in the invention may include an equivalent switch 401 and an equivalent capacitance 402 as shown in FIG. 4. A first terminal of the equivalent switch 401 may receive a clock signal CLK. A control terminal of the equivalent switch 401 is coupled to the control node G_P. A second terminal of the equivalent switch 401 is coupled to the gate output terminal G_out. The equivalent capacitance 402 is coupled between the control terminal and the second terminal of the equivalent switch 401. It should be noted that, in conjunction with the embodiment of FIG. 3 described above, the shared pull-up control circuit and pull-down control circuit described in the embodiment of FIG. 3 may be configured to control the control node G_P to control the equivalent switch 401 to output a corresponding first gate drive signal or a corresponding second gate drive signal from the (gate) output terminal G_out (i.e., the main output terminal or the boost output terminal described below) based on the clock signal CLK.

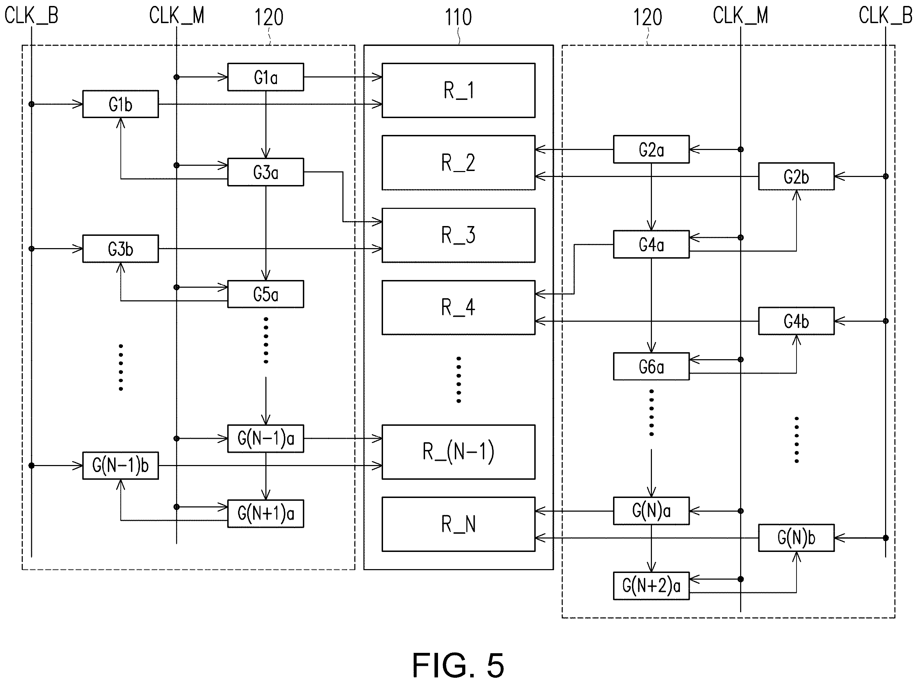

FIG. 5 is a schematic diagram of a pixel array and a gate driver circuit according to an embodiment of the invention. Referring to FIG. 5, in one embodiment, the pixel array 110 and the gate driver circuit 120 of FIG. 1 may implement the architecture as shown in FIG. 5. The pixel array 110 includes N rows R_1 to R_N of the pixel units, where N is a positive integer. The gate driver circuit 120 includes a plurality of stages of the gate drivers G1a to G(N+2)a, G1b to G(N)b. Every two stages of the gate drivers G1a to G(N+2)a, G1b to G(N)b are alternately arranged on both sides of pixel array 110. N stages of the plurality of stages of the gate drivers G1a to G(N+2)a, G1b to G(N)b generate 2N gate drive signals through shared control circuits to drive the pixel units of the N rows R_1 to R_N.

Specifically, gate drivers G1a to G(N+2)a are sequentially coupled one-to-one to the plurality of pixel units of the plurality of rows R_1 to R_N of the pixel array 110. The gate drivers G1b to G(N)b are sequentially coupled one-to-one to the plurality of pixel units of the plurality of rows R_1 to R_N of pixel array 110. The gate drivers G1a to G(N+2)a are configured to receive a first clock signal CLK_M (the main clock signal). The gate drivers G1b to G(N)b are configured to receive a second clock signal CLK_B (boost clock signal). The first clock signal CLK_M (main clock signal) and/or the second clock signal CLK_B (boost clock signal) may each include one or more clock signals.

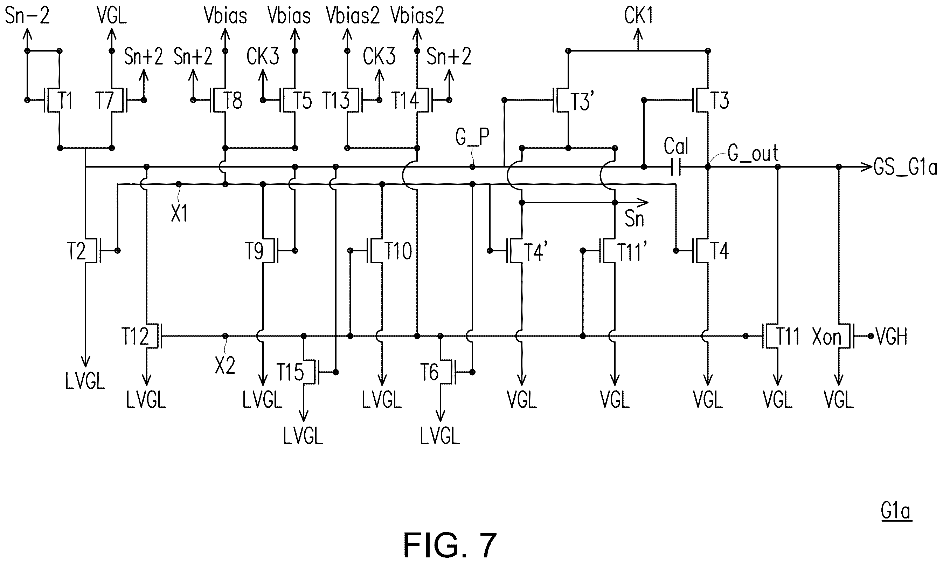

Each stage of the gate drivers G1a to G(N+2)a, G1b to G(N)b is also coupled to the preceding two stages and the following two stages of the gate drivers to share gate pulse voltage. For example, the gate driver G3a is also coupled to the gate driver G1a and the gate driver G5a, and the gate driver G5a is also coupled to the gate driver G3a and the gate driver G7a, and so on. It should be noted that the gate driver G3a may share control circuits with the gate driver G1b (such as the pull-up control circuit and the pull-down control circuit described in the embodiment of FIG. 3), and the gate driver G5a may share control circuits with the gate driver G3b (such as the pull-up control circuit and the pull-down control circuit described in the embodiment of FIG. 3), and so on. In this regard, the method of the adjacent two stages of the gate drivers sharing control circuits will be described in detail by the following embodiments of FIG. 7 to FIG. 8.

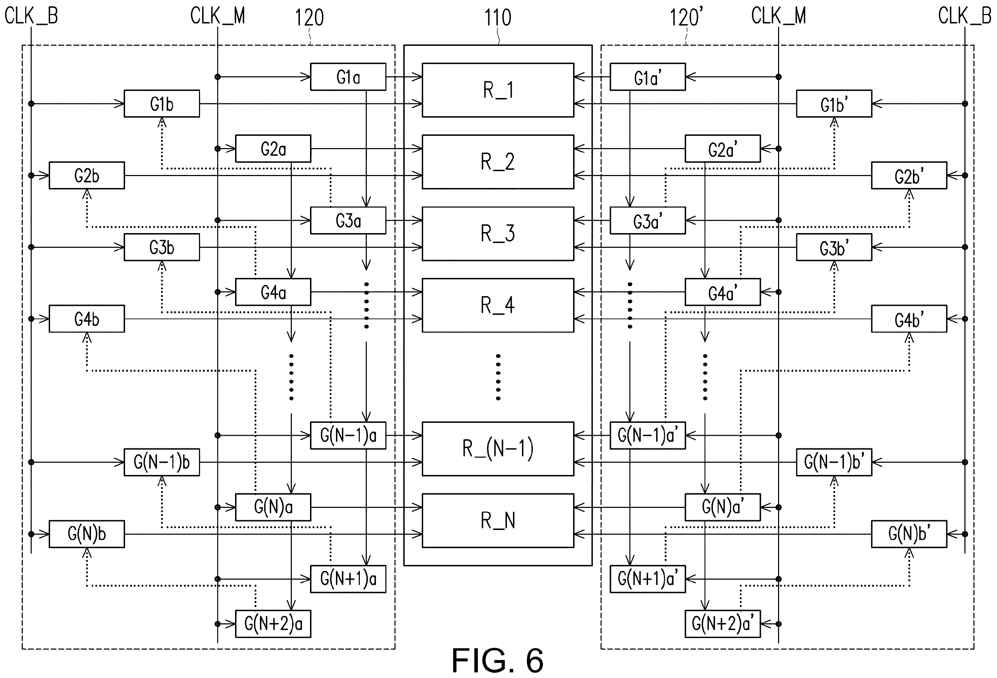

FIG. 6 is a schematic diagram of a pixel array and a gate driver circuit according to another embodiment of the invention. Referring to FIG. 6, in another embodiment, the pixel array 110 and the gate driver circuit 120 of FIG. 1 may implement the architecture shown in FIG. 6, and the display device 100 of FIG. 1 may further include the another gate driver circuit 120' as shown in FIG. 6. In one embodiment, the pixel array 110 includes a plurality of pixel units of the plurality of rows R_1 to R_N. The gate driver circuit 120 includes a plurality of stages of the gate drivers G1a to G(N+2)a, G1b to G(N)b. The gate driver circuit 120' includes the plurality of stages of the gate drivers G1a' to G(N+2)a', G1b' to G(N)b'. The gate driver circuit 120 and gate driver circuit 120' are respectively disposed on two sides of the pixel array 110. The gate driver circuit 120 and the gate driver circuit 120' drive the plurality of pixel units of the pixel array 110 in a dual-side driving method.

Specifically, the gate drivers G1a to G(N+2)a are sequentially coupled to the plurality of pixel units of the plurality of rows R_1 to R_N of the pixel array 110 on one side of the pixel array 110 by one-to-one. The gate drivers G1b to G(N)b are sequentially coupled to the plurality of pixel units of the plurality of rows R_1 to R_N of the pixel array 110 on one side of the pixel array 110 by one-to-one. The gate drivers G1a to G(N+2)a are configured to couple to a first clock signal line (i.e., the main clock signal line) to receive the first clock signal CLK_M (main clock signal). The gate drivers G1b to G(N)b are configured to couple to a second clock signal line (i.e., the boost clock signal line) to receive the second clock signal CLK_B (boost clock signal). The gate drivers G1a' to G(N+2)a' are sequentially coupled to the plurality of pixel units of the plurality of rows R_1 to R_N of the pixel array 110 on another side of the pixel array 110 by one-to-one. The gate drivers G1b' to G(N)b' are sequentially coupled to the plurality of pixel units of the plurality of rows R_1 to R_N of the pixel array 110 on another side of the pixel array 110 by one-to-one. The gate drivers G1a' to G(N+2)a' are configured to receive the first clock signal CLK_M (the main clock signal). The gate drivers G1b' to G(N)b' are configured to receive the second clock signal CLK_B (the boost clock signal).

Each stage of the gate drivers G1a to G(N+2)a, G1b to G(N)b is further coupled to the preceding two stages and the following two stages of the gate drivers to share gate pulse voltage. For example, the gate driver G3a is further coupled to the gate driver G1a and the gate driver G5a, and the gate driver G5a is further coupled to the gate driver G3a and the gate driver G7a, and so on. It should be noted that the gate driver G3a may share the control circuit with the gate driver G1b (such as the pull-up control circuit and pull-down control circuit described in the embodiment of FIG. 3), and the gate driver G5a may share the control circuit with the gate driver G3b (such as the pull-up control circuit and the pull-down control circuit described in the embodiment of FIG. 3), and so on.

Each stage of the gate drivers G1a' to G(N+2)a', G1b' to G(N)b' is further coupled to the preceding two stages and the following two stages of the gate drivers to share the gate pulse voltage. For example, the gate driver G3a' is further coupled to gate driver G1a' and the gate driver G5a', and the gate driver G5a' is further coupled to the gate driver G3a' and the gate driver G7a', and so on. It should be noted that the gate driver G3a' may share the control circuit with the gate driver G1b' (such as the pull-up control circuit and the pull-down control circuit described in the embodiment of FIG. 3), and the gate driver G5a' may share the control circuit with the gate driver G3b' (such as the pull-up control circuit and the pull-down control circuit described in the embodiment of FIG. 3), and so on.

Moreover, the configuration of the gate drivers G1a' to G(N)a', G1b' to G(N)b' is symmetrical to the gate drivers G1a to G(N)a, G1b to G(N)b, therefore no further elaboration is provided. In this regard, the method of the adjacent two stages of the gate drivers sharing the control circuit (such as the pull-up control circuit and the pull-down control circuit described in the embodiment of FIG. 3) will be described in detail by the following embodiments of FIG. 7 to FIG. 8.

FIG. 7 is a schematic diagram of a gate driver according to an embodiment of the invention. Referring to FIG. 7, the gate driver G1a of the above embodiments may have the circuit architecture as shown in FIG. 7. The gate driver G1a includes transistors T1 to T15, T3', T4', T11', Xon and a capacitor Ca1. The first terminal of the transistor T1 is coupled to the control terminal of the transistor T1, and receives cascade signal Sn-2 from the gate driver of the preceding two stages. The second terminal of the transistor T1 is coupled to the control node G_P. The first terminal of the transistor T2 is coupled to the control node G_P. The second terminal of the transistor T2 receives the reference voltage LVGL. The control terminal of the transistor T2 is coupled to node X1. The first terminal of the transistor T3 receives the clock signal CK1 (i.e., the aforementioned clock signal CLK_M includes clock signal CK1). The second terminal of the transistor T3 is coupled to the output terminal G_out (i.e., the main output terminal). The control terminal of the transistor T3 is coupled to the control node G_P.

The first terminal of the transistor T3' receives the clock signal CK1. The second terminal of the transistor T3' is coupled to the node SP. The control terminal of the transistor T3' is coupled to the control node G_P. The first terminal of the transistor T4 is coupled to the output terminal G_out (i.e., the main output terminal). The second terminal of the transistor T4 receives a reference voltage VGL. The control terminal of the transistor T4 is coupled to the node X1. The first terminal of the transistor T4' is coupled to the node SP. The second terminal of the transistor T4' receives the reference voltage VGL. The control terminal of the transistor T4' is coupled to the node X1. The first terminal of the transistor T5 receives the bias voltage Vbias. The second terminal of the transistor T5 is coupled to the node X1. The control terminal of the transistor T5 receives the clock signal CK3 (i.e., the aforementioned clock signal CLK_M includes the clock signal CK3).

The first terminal of the transistor T6 is coupled to the node X2. The second terminal of the transistor T6 receives the reference voltage LVGL. The control terminal of the transistor T6 is coupled to the control node G_P. The first terminal of the transistor T7 receives the reference voltage VGL. The second terminal of the transistor T7 is coupled to the control node G_P. The control terminal of the transistor T7 receives a cascade signal Sn+2 from the gate driver of the following two stages. The first terminal of the transistor T8 receives the bias voltage Vbias. The second terminal of the transistor T8 is coupled to the node X1. The control terminal of the transistor T8 receives the cascade signal Sn+2 from the gate driver of the following two stages. The first terminal of the transistor T9 is coupled to the node X1. The second terminal of the transistor T9 receives the reference voltage LVGL. The control terminal of the transistor T9 is coupled to the control node G_P.

The first terminal of the transistor T10 is coupled to the node X1. The second terminal of the transistor T10 receives the reference voltage LVGL. The control terminal of the transistor T10 is coupled to the node X2. The first terminal of the transistor T11 is coupled to the output terminal G_out (i.e., main output terminal). The second terminal of the transistor T11 receives the reference voltage VGL. The control terminal of the transistor T11 is coupled to the node X2. The first terminal of the transistor T11' is coupled to the node SP. The second terminal of the transistor T11' receives the reference voltage VGL. The control terminal of the transistor T11' is coupled to the node X2. The first terminal of the transistor T12 is coupled to the control node G_P. The second terminal of the transistor T12 receives the reference voltage LVGL. The control terminal of the transistor T12 is coupled to the node X2.

In the embodiment, the first terminal of the transistor T13 receives bias voltage Vbias2. The second terminal of the transistor T13 is coupled to the node X2. The control terminal of the transistor T13 receives the clock signal CK3. The first terminal of the transistor T14 receives the bias voltage Vbias2. The second terminal of the transistor T14 is coupled to the node X2. The control terminal of the transistor T14 receives the cascade signal Sn+2 from the gate driver of the following two stages. The first terminal of the transistor T15 is coupled to the node X2. The second terminal of the transistor T15 receives the reference voltage LVGL. The control terminal of the transistor T15 is coupled to the control node G_P. The first terminal of the transistor Xon is coupled to the output terminal G_out (i.e., the main output terminal). The second terminal of the transistor Xon receives the reference voltage VGL. The control terminal of the transistor Xon receives the reference voltage VGH. The first terminal of the capacitor Ca1 is coupled to the control node G_P. The second terminal of the capacitor Ca1 is coupled to the output terminal G_out (i.e., the main output terminal).

In the embodiment, the transistors T1 and T3' compose the pull-up control circuit 311 of the gate driver G1a in FIG. 3. The transistors T2, T4', and T5 to T15 compose the pull-down control circuit 312 of the gate driver G1a in FIG. 3. The transistor T3 composes the pull-up circuit 313 of the gate driver G1a in FIG. 3. The transistors T4, T11, and Xon compose the pull-down circuit 314 of the gate driver G1a in FIG. 3. It should be noted that the node SP outputs the cascade signal Sn to the gate drivers of the preceding two stages and the following two stages. The output terminal G_out (i.e., main output terminal) outputs the first gate drive signal GS_G1a to the plurality of pixel units in the first row of the pixel array.

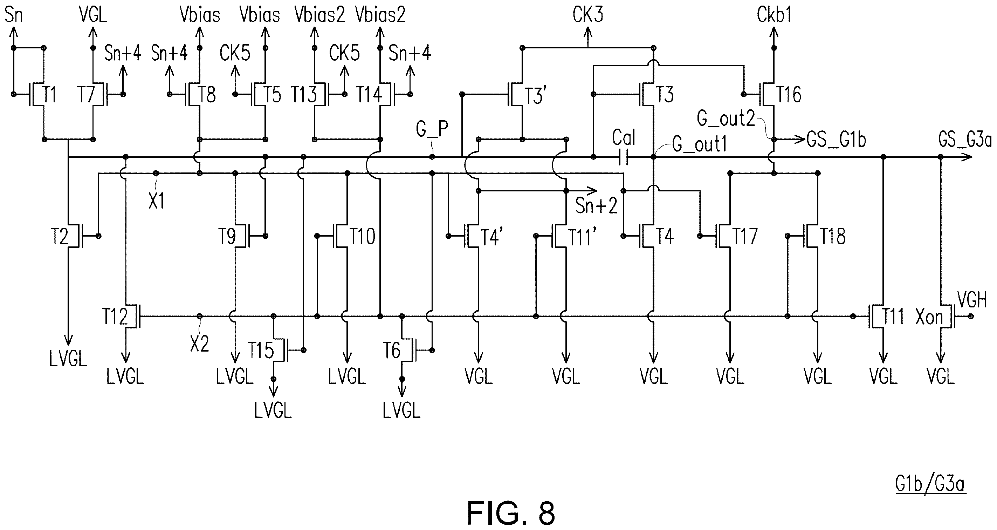

FIG. 8 is a schematic diagram of another gate driver according to an embodiment of the invention. Referring to FIG. 8, the gate drivers G1b and G3a of the above implementations may have the circuit architecture as shown in FIG. 8. The gate drivers G1b and G3a include transistors T1 to T18, T3', T4', T11', Xon, and a capacitor Ca1. It should be noted that the coupling method of the transistors T1 to T15, T3', T4', T11', Xon, and the capacitor Ca1 is the same as that of the gate driver G1a in FIG. 7, and therefore will not be described in detail.

Different from FIG. 7, the control terminal of the transistor T1 receives the cascade signal Sn from the gate driver of the preceding two stages. The control terminals of the transistors T7, T8, and T14 receive the cascade signal Sn+4 from the gate driver of the following two stages. The first terminals of the transistors T3 and T3' receive the clock signal CK3. The control terminals of transistors T5 and T13 receive the clock signal CK5 (i.e., the aforementioned clock signal CLK_M includes the clock signal CK5). The node SP outputs the cascade signal Sn+2 to the gate drivers of the preceding two stages and the following two stages.

Different from FIG. 7, the gate drivers G1b and G3a may additionally include at least one boost clock signal line, at least one output transistor of the boost output terminal, and two or three key pull-down transistors. Specifically, the first terminal of the transistor T16 may be coupled to the boost clock signal line to receive the second clock signal Ckb1 (the boost clock signal) (i.e., the aforementioned clock signal CLK_B includes the clock signal Ckb1). The control terminal of the transistor T16 is coupled to the control node G_P. The second terminal of the transistor T16 is coupled to the output terminal G_out2 (i.e., the boost output terminal). The transistor T16 serves as the output transistor of the boost output terminal. The first terminal of the transistor T17 is coupled to the output terminal G_out2 (i.e., the boost output terminal). The control terminal of the transistor T17 is coupled to the node X1. The second terminal of the transistor T17 receives the reference voltage VGL. The first terminal of the transistor T18 is coupled to the output terminal G_out2 (i.e., the boost output terminal). The control terminal of the transistor T18 is coupled to the node X2. The second terminal of the transistor T18 receives the reference voltage VGL. The transistors T17 and T18 serve as key pull-down transistors, and the number of key pull-down transistors is not limited to that shown in FIG. 8. Moreover, the effective size (e.g., the transistor length and width) of the transistors T17 and T18 of the gate drivers G1b and G3a may be smaller than the effective size of the pull-down transistors (i.e., for example, the transistors T4 and T11 in FIG. 7) of the gate driver G1a belonging to the output terminal G_out (i.e., the main output terminal) shown in FIG. 7.

The transistors T1 and T3' are configured to compose the pull-up control circuit 331 of the gate driver G3a in FIG. 3. The transistors T2, T4', and T5 to T15 are configured to compose the pull-down control circuit 332 of the gate driver G3a in FIG. 3. The transistor T3 is configured to compose the pull-up circuit 333 of the gate driver G3a in FIG. 3. The transistors T4, T11, and Xon are configured to compose the pull-down circuit 334 of the gate driver G3a in FIG. 3. The node SP is configured to output cascade signal Sn+2 to the gate drivers of the preceding two stages and the following two stages. The output terminal G_out1 (i.e., the main output terminal) is configured to output the first gate drive signal GS_G3a to the plurality of pixel units in the second row of the pixel array. The first gate drive signal GS_G3a is the output potential of the output terminal G_out1. In the embodiment, the pull-up control circuit composed of the transistors T1 and T3' and the pull-down control circuit composed of the transistors T2, T4', and T5 to T15 are configured to control the potential variation of the control node G_P.

It should be noted that the transistor T16 is configured to compose the pull-up circuit 323 of the gate driver G1b in FIG. 3. The transistors T17 and T18 are configured to compose the pull-down circuit 324 of the gate driver G1b in FIG. 3. In this regard, the gate driver G1b and the gate driver G3a share the pull-up control circuit 331 composed of the transistors T1 and T3', and share the pull-down control circuit 332 composed of the transistors T2, T4', and T5 to T15. The output terminal G_out2 (i.e., the boost output terminal) is configured to output the second gate drive signal GS_G1b to the plurality of pixel units in the first row of the pixel array. The second gate drive signal GS_G1b is the output potential of the output terminal G_out2 (i.e., the boost output terminal). Moreover, the gate driver G1b to which the output terminal G_out2 (i.e., the boost output terminal) belongs and the gate driver G3a to which the main output terminal G_out1 of at least one adjacent stage belongs share the control path for controlling control node G_P, but do not share the output paths of the gate output terminals G_out1 and G_out2.

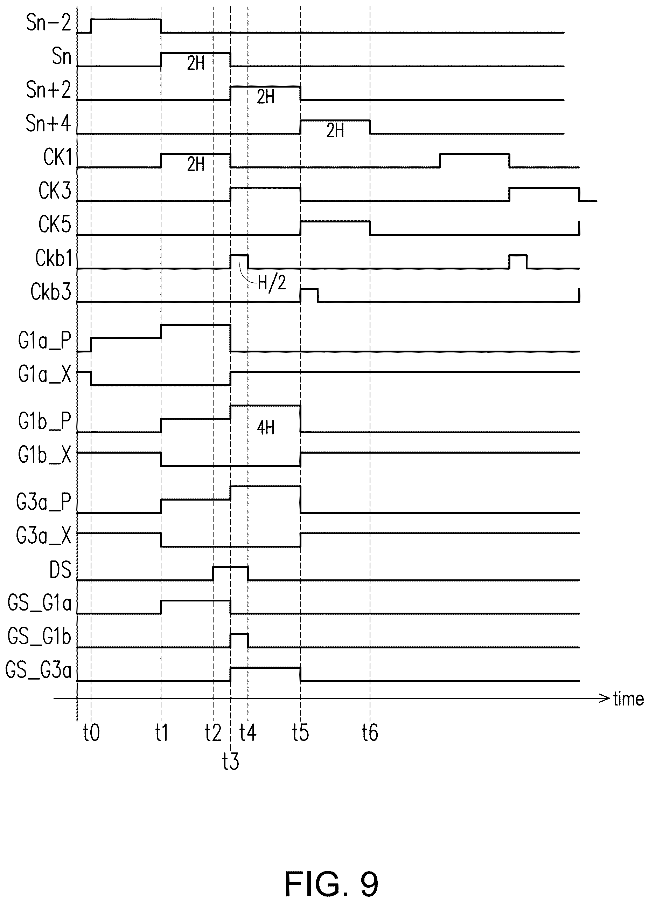

FIG. 9 is a timing diagram of a plurality of signals of the embodiments of FIG. 7 and FIG. 8 of the invention. Referring to FIG. 7 to FIG. 9, from time t0 to time t1, for the gate driver G1a, the cascade signal Sn-2 is switched to the high voltage level to make the transistor T1 operated in the conduction state and make the transistor T9 operated in the conduction state, so the node voltage G1a_P of the control node G_P may correspondingly switch to the high voltage level to charge the capacitor Ca1, and the node voltage G1a_X of the node X1 is pulled down to the reference voltage LVGL. During the period from time t1 to time t3, the clock signal CK1 switches to the high voltage level to make the cascade signal Sn synchronously switch to the high voltage level via the transistor T3', and make the voltage level of the node voltage G1a_P of the control node G_P further boosted. Therefore, based on voltage coupling of the capacitor Ca1, the output terminal G_out (i.e., the main output terminal) may output the first gate drive signal GS_G1a with the high voltage level to the plurality of pixel circuits in the first row of the pixel array. Moreover, for the gate driver G1b/G3a, since the cascade signal Sn switches to the high voltage level, the transistor T1 is operated in conduction state and makes the transistor T9 operated in the conduction state, so the node voltages G1b_P and G3a_P of the control node G_P may be correspondingly switched to the high voltage level to charge the capacitor Ca1, and the node voltages G1b_X and G3a_X of the node X1 are pulled down to the reference voltage LVGL. The data signal DS may write data voltage to the pixel circuit during the period from time t2 to time t4.

During the period from time t3 to time t5, for the gate driver G1b/G3a, the clock signal CK3 is switched to the high voltage level to make the cascade signal Sn+2 synchronously switched to the high voltage level via the transistor T3', and make the voltage levels of the node voltages G1b_P and G3a_P of the control node G_P further boosted. Therefore, based on the voltage coupling of the capacitor Ca1, the output terminal G_out1 (i.e., the main output terminal) may output the first gate drive signal GS_G3a with the high voltage level to the plurality of pixel circuits in the second row of the pixel array. In addition, for the gate driver G1a, the clock signal CK3 is switched to the high voltage level to make the transistor T5 operated in the conduction state, so the node voltage G1a_X of the node X1 is switched to the bias voltage Vbias.

During the period from time t3 to time t4, for the gate driver G1b/G3a, the clock signal CKb1 is switched to the high voltage level. Since the transistor T16 is operated in the conduction state based on the node voltages G1b_P and G3a_P being at the high voltage level, the output terminal G_out2 (i.e., boost output terminal) may output the second gate drive signal GS_G1b with the high voltage level to the plurality of pixel circuits in the first row of the pixel array. Therefore, the plurality of pixel circuits in the first row of the pixel array may receive the first gate drive signal GS_G1a and the second gate drive signal GS_G1b with the non-overlapping conduction periods during the period from time t1 to time t4, and may effectively make the pixel voltage in the pixel circuits effectively boosted to the high voltage level. It should be noted that the first gate drive signal GS_G1a and the second gate drive signal GS_G1b have different duty cycles. The duty cycle of the second gate drive signal GS_G1b may be smaller than the duty cycle of the first gate drive signal GS_G1a. The first gate drive signal GS_G1a has, for example, a conduction period with time length of 2 vertical synchronization periods (2H). The second gate drive signal GS_G1b has, for example, a conduction period with time length of 1/2 vertical synchronization period (1/2H). Moreover, the next stage gate driver circuit may perform the aforementioned operations according to the cascade signal Sn+4, the clock signals CK5, Ckb3 (i.e., the aforementioned clock signal CLK_B includes the clock signal Ckb3).

For example, as pixel circuit 200 shown in FIG. 2, the first gate drive signal GS_G1a and the second gate drive signal GS_G1b in FIG. 8 may serve as the first gate drive signal GS1 and the second gate drive signal GS2 in FIG. 2. In this way, during the period from time t1 to time t3, the pixel transistors Tp1 and Tp2 may be operated in the conduction state, and the pixel transistor Tp3 is operated in the cut-off state, so the bootstrap capacitor Cboost may be pre-charged by the data voltage of the data signal DS via the pixel transistor Tp1. The node voltage Vq may be the reference voltage Vcom, and the pixel voltage Vp may be the data voltage of the data signal DS. Then, during the period from time t3 to time t4, the pixel transistors Tp1 and Tp2 may be operated in the cut-off state, and the pixel transistor Tp3 is operated in the conduction state, so the voltage of the bootstrap capacitor Cboost may be further boosted by the data voltage of the data signal DS via the pixel transistor Tp3. The node voltage Vq may be the data voltage of the data signal DS, and the pixel voltage Vp may, for example, be further boosted to twice the data voltage. Therefore, the pixel capacitor Cfpl may be effectively applied with the pixel voltage Vp having corresponding high voltage level.

In another implementation, the aforementioned another type of the pixel circuit (i.e., the two-transistor bootstrap pixel circuit including the first pixel transistor, the second pixel transistor, first capacitor and the second capacitor) may also be driven by the first gate drive signal GS_G1a and the second gate drive signal GS_G1b output by the gate driver of FIG. 8, where the first gate drive signal GS_G1a corresponds to the first gate drive signal GS1, and the second gate drive signal GS_G1b corresponds to the second gate drive signal GS2. Specifically, during the first period from time t1 to time t3, the first gate drive signal GS1 (i.e., GS_G1a) is switched to the high voltage level, causing the first pixel transistor to operate in the conduction state to charge the first node N1 to the first voltage according to the data signal (or first data signal). Then, during the second period from time t3 to time t4, the second gate drive signal GS2 (i.e., GS_G1b) is switched to the high voltage level, causing the second pixel transistor to operate in the conduction state while first pixel transistor is operated in the cut-off state. During this period, the second node N2 is charged to the second voltage according to the data signal (or the second data signal), causing potential difference across the first capacitor to change, thereby the boosting pixel voltage provided by the first node N1 from the first voltage substantially to the third voltage through capacitive coupling (bootstrap effect), where the third voltage is substantially equal to sum of the first voltage and the second voltage. The voltage range of the third voltage is substantially -24 volts to +24 volts, while the voltage range of the data signal is substantially -15 volts to +15 volts. Therefore, by outputting the first gate drive signal GS1 and the second gate drive signal GS2 with the non-overlapping conduction periods through the gate driver circuit of the invention, the bootstrap boosting operation of the two-transistor bootstrap pixel circuit may be effectively coordinated, while reducing voltage output requirements for the data driver circuit and effectively saving the layout area of the gate driver circuit through shared control circuit of the multi-stage gate drivers, achieving dual optimization of drive circuit area and cost.

In one implementation, the gate driver circuit 120 of the invention (i.e., the gate driver array circuit including the multi-stage gate drivers) may be combined with a data multiplexer and applied to the same display device 100. The data multiplexer is coupled the data driver IC and the pixel data lines in the pixel array 110, where each multiplexer circuit includes a first transistor (the output transistor), the bootstrap capacitor, the diode, and the second transistor (the reset transistor). Through capacitive coupling effect of the bootstrap capacitor, the control terminal voltage of the output transistor in the multiplexer circuit may be boosted to sufficiently high level (e.g., up to positive 68 volts) to ensure that the data signals with the voltage range of positive and negative 24 volts may be smoothly and accurately transmitted to each pixel unit of the pixel array 110 employing the bootstrap gate circuit of the invention. Furthermore, in pixel circuit implementations containing dual data signal line architecture (such as the aforementioned two-transistor bootstrap pixel circuit including the first data signal line and the second data signal line), the first data signal line and the second data signal line may respectively correspond to the output terminals of the two independent multiplexer circuits in the data multiplexer, where each multiplexer circuit is respectively responsible for MUX bootstrap boosting transmission of its corresponding data signal line to ensure that both the first data signal and the second data signal may be written into the pixel circuit with sufficient voltage levels. The gate driver circuit 120 and the data multiplexer respectively and independently solve the high voltage specification issues under the bootstrap pixel circuit architecture on the gate side and the data side. For example, the gate driver circuit 120 generates 2N gate drive signals through architecture of the N-stage gate driver shared control circuit, which may effectively suppress layout area growth of the gate driver circuit. Moreover, the data multiplexer enables the number of the chip data lines to be reduced to the one-Kth of the number of the pixel data lines (K is a positive integer greater than or equal to 2), and eliminates dependence on external high voltage drive systems (such as booster). The combined benefits of both constitute a system-level low-voltage driving solution suitable for bootstrap electronic paper pixel circuits with low cost and low power consumption (system-level low-voltage driving solution).

In summary, the display device of the invention may effectively save circuit layout space of the gate driver circuit by sharing the pull-up control circuit and the pull-down control circuit between adjacent two-stage gate drivers, and may effectively generate corresponding two gate drive signals with non-overlapping conduction periods to the plurality of pixel units in each row of the pixel array to effectively drive corresponding display components.

## Claims

1. A display device (100), comprising:
a pixel array (110), comprising a plurality of pixel units (P(1,1) to P(M,N)); and
a gate driver circuit (120), coupled to the pixel array (110), and comprising a plurality of stages of gate drivers (G1a to G(N+2)a, G1b to G(N)b, G1a' to G(N+2)a', G1b' to G(N)b'),
wherein at least one stage of the plurality of stages of gate drivers (G1a to G(N+2)a, G1a' to G(N+2)a') is configured to receive a first clock signal (CLK_M), and has a main output terminal (G_out, G_out1) configured to output a first gate drive signal (GS1),
wherein at least another stage of the plurality of stages of gate drivers (G1b to G(N)b, G1b' to G(N)b') is configured to receive a second clock signal (CLK_B), and has a boost output terminal (G_out2) configured to output a second gate drive signal (GS2),
wherein the gate driver (G1b to G(N)b, G1b' to G(N)b') to which the boost output terminal (G_out2) belongs shares a control circuit with the gate driver (G1a to G(N+2)a, G1a' to G(N+2)a') to which the main output terminal (G_out, G_out1) of at least one adjacent stage belongs.

2. The display device (100) according to claim 1, wherein the gate driver (G1b to G(N)b, G1b' to G(N)b') to which the boost output terminal (G_out2) belongs shares the control circuit with at least two adjacent stages of the gate drivers (G1a to G(N+2)a, G1a' to G(N+2)a').

3. The display device (100) according to claim 1, wherein the first gate drive signal (GS1) and the second gate drive signal (GS2) are coupled to the same row of the plurality of pixel units (P(1,1) to P(M,N)).

4. The display device (100) according to claim 3, wherein one stage of the plurality of stages of gate drivers (G1a to G(N+2)a, G1a' to G(N+2)a') receives the first clock signal (CLK_M), and another stage of the plurality of stages of the gate drivers (G1b to G(N)b, G1b' to G(N)b') receives the second clock signal (CLK_B).

5. The display device (100) according to claim 3, wherein conduction periods of the first gate drive signal (GS1) and the second gate drive signal (GS2) do not overlap.

6. The display device (100) according to claim 3, wherein the first gate drive signal (GS1) and the second gate drive signal (GS2) have different duty cycles.

7. The display device (100) according to claim 6, wherein the duty cycle of the second gate drive signal (GS2) is smaller than the duty cycle of the first gate drive signal (GS1).

8. The display device (100) according to claim 1, wherein a voltage amplitude of the second clock signal (CLK_B) is different from a voltage amplitude of the first clock signal (CLK_M).

9. The display device (100) according to claim 4, wherein a pull-up circuit (323, 343) of the another stage of the plurality of stages of the gate drivers (G1b to G(N)b, G1b' to G(N)b') comprises:
a first transistor (T16), wherein a first terminal of the first transistor (T16) receives the second clock signal (CLK_B), and a second terminal of the first transistor (T16) is configured to output the second gate drive signal (GS2).

10. The display device (100) according to claim 9, wherein a pull-down circuit (324, 344) of the another stage of the plurality of stages of the gate drivers (G1b to G(N)b, G1b' to G(N)b') comprises:
a second transistor (T17), wherein a first terminal of the second transistor (T17) is coupled to the second terminal of the first transistor (T16); and
a third transistor (T18), wherein a first terminal of the third transistor (T18) is coupled to the second terminal of the first transistor (T16).

11. The display device (100) according to claim 3, wherein a pixel circuit (200) of each of the plurality of pixel units (P(1,1) to P(M,N)) comprises:
a first pixel transistor (Tp1), coupled to a first node (N1), wherein a control terminal of the first pixel transistor (Tp1) receives the first gate drive signal (GS1);
a second pixel transistor (Tp2), coupled to a second node (N2), wherein a control terminal of the second pixel transistor (Tp2) receives the first gate drive signal (GS1);
a third pixel transistor (Tp3), coupled to the second node (N2), wherein a control terminal of the third pixel transistor (Tp3) receives the second gate drive signal (GS2);
a bootstrap capacitor (Cboost), coupled between the first node (N1) and the second node (N2); and
a pixel capacitor (Cfpl), coupled to the first node (N1),
wherein the first node (N1) is configured to provide a pixel voltage to the pixel capacitor (Cfpl).

12. The display device (100) according to claim 1, wherein compared to the at least one stage of the plurality of stages of the gate drivers (G1a to G(N+2)a, G1a' to G(N+2)a'), at least another one stage of the plurality of stages of gate drivers (G1b to G(N)b, G1b' to G(N)b') further comprises:
at least one boost clock signal line, an output transistor of at least one boost output terminal (G_out2), and two or three key pull-down transistors.

13. The display device (100) according to claim 12, wherein an effective size of the key pull-down transistors is smaller than an effective size of pull-down transistors disposed in the gate driver (G1a to G(N+2)a, G1a' to G(N+2)a') belonging to the main output terminal (G_out, G_out1).

14. The display device (100) according to claim 1, wherein every two stages of the plurality of stages of the gate drivers (G1a to G(N+2)a, G1b to G(N)b, G1a' to G(N+2)a', G1b' to G(N)b') are alternately disposed on two sides of the pixel array (110).

15. The display device (100) according to claim 1, further comprising:
another gate driver circuit (120') coupled to the pixel array (110),
wherein the gate driver circuit (120) and the another gate driver circuit (120') are respectively disposed on two sides of the pixel array (110), and the gate driver circuit (120) and another gate driver circuit (120') drive the plurality of pixel units (P(1,1) to P(M,N)) of the pixel array (110) in a dual-side driving method.

16. The display device (100) according to claim 1, wherein the display device (100) is a bistable display.

17. The display device (100) according to claim 1, wherein the control circuit is configured to control a potential change of an internal control node (G_P), and the first gate drive signal (GS 1) and the second gate drive signal (GS2) are output potentials of different gate output terminals,
wherein the gate driver (G1b to G(N)b, G1b' to G(N)b') belonging to the boost output terminal (G_out2) and the gate driver (G1a to G(N+2)a, G1a' to G(N+2)a') belonging to the main output terminal (G_out, G_out1) of at least one adjacent stage share a control path for controlling the internal control node (G_P), but do not share an output path of the gate output terminal.

18. The display device (100) according to claim 1, wherein the pixel array (110) comprises N rows of the pixel units (P(1,1) to P(M,N)), N stages of the plurality of stages of the gate drivers (G1a to G(N+2)a, G1b to G(N)b, G1a' to G(N+2)a', G1b' to G(N)b') generate 2N gate drive signals through sharing the control circuit to drive the N rows of the pixel units (P(1,1) to P(M,N)), wherein N is a positive integer.

19. The display device (100) according to claim 1, wherein the first clock signal (CLK_M) and/or the second clock signal (CLK_B) each comprises one or a plurality of clock signals.
